(19) Europäisches Patentamt
European Patent Office
Office européen des brevets

(11) **EP 4 064 801 A1**

(12) **EUROPEAN PATENT APPLICATION**

(43) Date of publication:
**28.09.2022 Bulletin 2022/39**

(21) Application number: **22157644.0**

(22) Date of filing: **21.02.2022**

(51) International Patent Classification (IPC):
**H05K 1/02** *(2006.01)*    **H05K 1/11** *(2006.01)*
**H05K 1/16** *(2006.01)*    **H01P 1/203** *(2006.01)*
**H04B 5/00** *(2006.01)*    H05K 3/42 *(2006.01)*

(52) Cooperative Patent Classification (CPC):
**H04B 5/0012; H05K 1/0216; H05K 1/115;**
**H05K 1/162;** H01P 1/203; H05K 1/0231;
H05K 3/429; H05K 2201/09236; H05K 2201/09636

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.03.2021 US 202117214766**

(71) Applicant: **INTEL Corporation
Santa Clara, CA 95054 (US)**

(72) Inventors:
 • **Drew, John R.
  Hillsboro OR, 97124 (US)**
 • **Christianson, Stephen P.
  Tigard OR, 97223 (US)**
 • **Padigi, Sudhaprasanna
  Portland OR, 97229 (US)**
 • **Pineda, Esteban Torres
  50101 Liberia (CR)**

(74) Representative: **Samson & Partner Patentanwälte mbB
Widenmayerstraße 6
80538 München (DE)**

(54) **VIA COUPLING STRUCTURES TO REDUCE CROSSTALK EFFECTS**

(57) In one embodiment, an apparatus includes first and second via structures in a substrate. Each via structure defines a coupling element that extends from the via structure toward the other via structure such that the coupling elements capacitively couple with one another in an area between the first and second via structures.

**FIG. 1A**

EP 4 064 801 A1

**Description**

TECHNICAL FIELD

This disclosure relates in general to the field of computer systems and, more particularly, to via coupling structures to reduce crosstalk effects.

BACKGROUND

In high-speed single-ended buses (e.g., in memory), neighboring channels may experience crosstalk effects, such as far-end crosstalk (FEXT) from neighboring signals. These effects may be a detrimental noise source on an analog bus. Current means for addressing FEXT have a number of limitations.

BRIEF DESCRIPTION OF THE DRAWINGS

FIGS. 1A-1B illustrate an example of via structures capacitively coupled to one another through a via coupling structure in accordance with embodiments of the present disclosure.

FIG. 2 illustrates the example via structures of FIGS. 1A-1B on a printed circuit board that includes other via structures in accordance with embodiments of the present disclosure.

FIGS. 3A-3C illustrate example via coupling structures in accordance with embodiments of the present disclosure.

FIGS. 4A-4B illustrate another example via coupling structure in accordance with embodiments of the present disclosure.

FIGS. 5A-5B illustrate another example of via structures capacitively coupled to one another in accordance with embodiments of the present disclosure.

FIGS. 6A-6B illustrate yet another example of via structures capacitively coupled to one another in accordance with embodiments of the present disclosure.

FIG. 7 illustrates an example printed circuit board having sets of three or more vias capacitively coupled together using via coupling structures in accordance with embodiments of the present disclosure.

FIGS. 8A-8B illustrate example simulation results for via coupling structures of an example circuit in accordance with embodiments of the present disclosure.

FIGS. 9A-9B illustrate additional example simulation results for another example via coupling structure in accordance with embodiments of the present disclosure.

FIG. 10A illustrates an example via coupling structure between vias and a ground plane that defines a void around the vias and via coupling structure in accordance with embodiments of the present disclosure.

FIG. 10B illustrates example simulation results related to the voided ground plane as shown in FIG. 10A.

FIG. 11 is an example illustration of a processor according to an embodiment.

FIG. 12 illustrates a computing system that is arranged in a point-to-point (PtP) configuration according to an embodiment.

Like reference numbers and designations in the various drawings indicate like elements.

DETAILED DESCRIPTION OF EXAMPLE EMBODIMENTS

In the following description, numerous specific details are set forth, such as examples of specific configurations, structures, architectural details, etc. in order to provide a thorough understanding of the present disclosure. It will be apparent, however, to one skilled in the art that these specific details need not be employed to practice embodiments of the present disclosure. In some instances, well known components or methods may be utilized, and such details haven't been described in detail in order to avoid unnecessarily obscuring embodiments of the present disclosure.

In high-speed single-ended buses (e.g., in memory), neighboring channels may experience crosstalk effects, such as far-end crosstalk (FEXT) from neighboring signals. These effects may be a detrimental noise source on an analog bus. Accordingly, aspects of the present disclosure include via coupling structures that may cancel much of the noise introduced along this physical route by modulating mutual capacitance to balance the inductive portion of far-end crosstalk accumulation. The via coupling structures of the present disclosure may be able to be tuned to achieve this benefit.

Current systems to address this issue have included "stubby line" or "tabbed routing" approaches. However, these may be applicable only to microstrip routes which are now only rarely used in Memory buses (e.g., due to increased crosstalk, even with stubby-line, versus conventional stripline and due to RFI introduced by surface routing). Stubby line may also be incapable of addressing FEXT introduced from vertical transitions which, in today's ecosystems, constitute the majority of noise injection. Another current approach includes "coupled via" technologies, in which pads emanating from one SoC package PTH on N-1 package layer are placed above package LGA landing pad to modulate mutual capacitance in an effort to reduce far-end crosstalk noise. These approaches, however, are only applicable to SoC package structures due to the fine routing dimensions required to instantiate and have little flexibility in tuning. In addition, the large capacitive stub created in this approach can sufficiently decrease structure impedance such that ISI degradation largely cancels any crosstalk benefits the structure brings.

In contrast, embodiments of the present disclosure includes routing structures or traces emanating from neighboring vias (e.g., signal vias of a printed circuit board) that capacitively couple onto one another to reduce component FEXT. The size and shape of these structures may be tuned to mitigate the inductive portion of FEXT generation for that particular component or group of components (e.g., package PTH, Socket, or MB Vias). Due to the flexibility of implementation, these via coupling structures may be placed at multiple locations throughout the physical route, and each may be designed specifically to best cancel crosstalk at their particular location. Via coupling structures of the present disclosure may accordingly increase bus performance without additional cost to customers by reducing system noise. This may take the form of, in certain instances, previously-unattainable signaling rates or, conversely, of isodata rate signaling with weaker Ron/ODT in an effort to save power.

In analog signaling, far-end crosstalk (FEXT) is proportional to the quantity $\left[\frac{C_m}{C_s} - \frac{L_m}{L_s}\right]$, where $C_m$, $C_s$, $L_m$, and $L_s$ refer to mutual capacitance, self-capacitance, mutual inductance, and self-inductance respectively. Typically, the inductive portion of this constant dominates the capacitive element resulting in FEXT signals of opposite polarity to the inducing step. This invention seeks to reduce FEXT by increasing the $C_m$ term and thus reducing the proportionality constant. Thought of alternatively, the coupling structure serves as an R/C analog differentiator, producing a counter-pulse to the original step-induced FEXT response.

It will be understood that the via coupling structures of the present disclosure may be placed in multiple location along a single channel. One may, for example, implement one set of via coupling structures on a PKG PTH to take advantage of fine package routing dimensions to cancel strong crosstalk from the socket transition. Near the DIMM field, one may again instantiate via coupling structures, this time on the motherboard, to cancel crosstalk accumulated through the bulk of the channel. These structures also necessitate no new manufacturing design rules or cost-adders to implement. For instance, these structures may be implemented in motherboard instantiations, e.g., on a low-cost four layer 4L T3 motherboard.

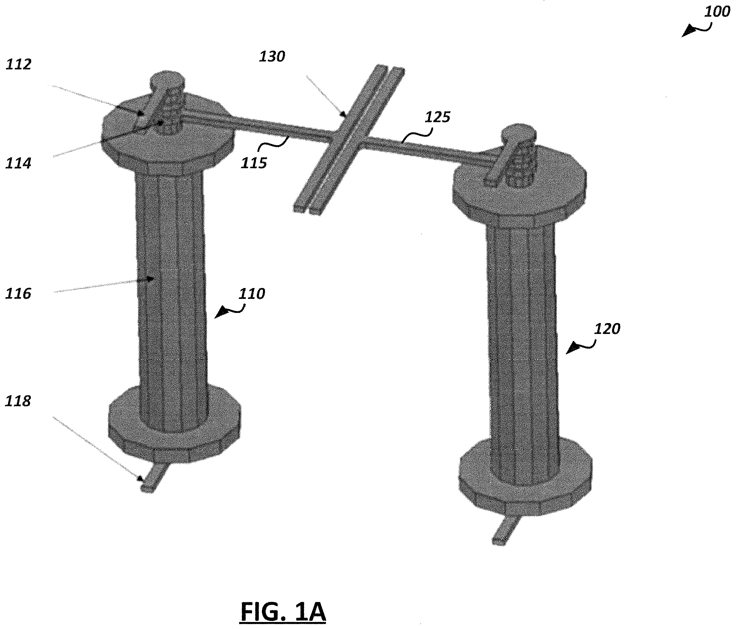

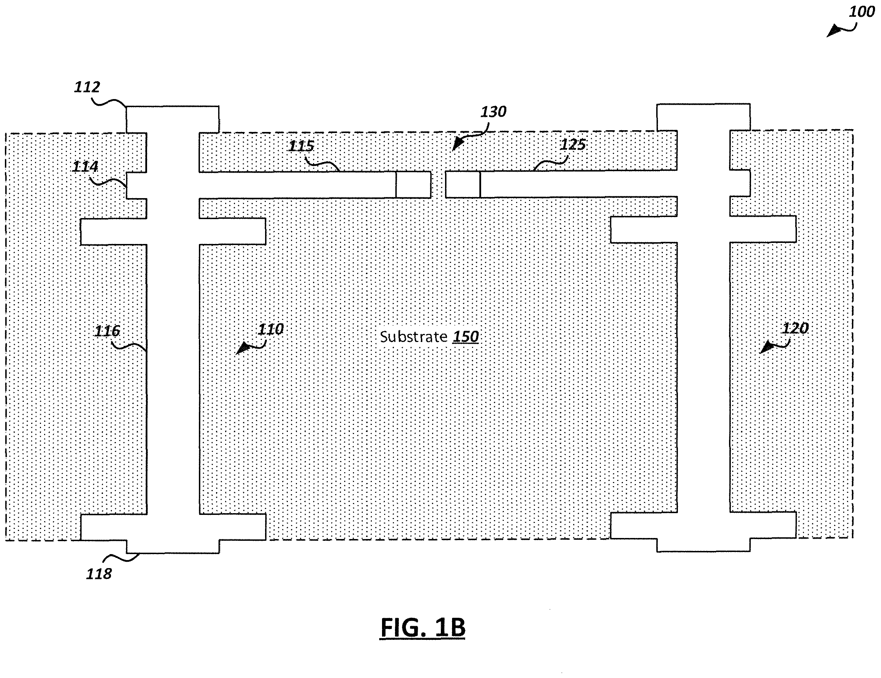

FIGS. 1A-1B illustrate an example of via structures 110, 120 capacitively coupled to one another through a via coupling structure 130 in accordance with embodiments of the present disclosure. In the example shown, each via structure 110, 120 includes a signal entry point (e.g., 112), a signal exit point (e.g., 118), a micro-via transition (e.g., 114) on a layer between the entry and exit, and a barrel portion (e.g., 116) that couples the entry and exit and other layers (e.g., a plated thru hole (PTH) barrel, blind via hole (BVH) barrel, or buried via hole (BVH) barrel). The via structures may accordingly allow a signal to travel from the entry point through substrate 150 to the exit point. The entry and/or exit points may be outside or within the substrate 150, depending on the application.

Each via structure 110, 120 further defines a trace (115, 125, respectively) that extends toward the other via structure. The traces 115, 125 form the coupling structure 130 in an area between the via structures 110, 120, and the coupling structure 130 provides a capacitive coupling between the via structures 110, 120. In the example shown, the traces 115, 125 are formed in a T-shape, with the top of the T-shapes being parallel with one another. In some embodiments, e.g., that shown in FIGS. 1A-1B, the via coupling structure 130 is positioned in the substrate 150 between the entry (e.g., 112) and exit points (e.g., 118), which may provide an optimal crosstalk-reducing effect. However, other embodiments may include the via coupling structure 130 positioned in another manner (e.g., on the same layer as the entry or exit). In addition, although one coupling structure 130 is shown, other coupling structures may exist between the via structures 110, 120 (e.g., as described below). Further, the shape and form of the example coupling structure 130 shown in FIGS. 1A-1B is merely one example of a coupling structure that may be used to reduce crosstalk effects in accordance with the present disclosure. Additional examples are described further below.

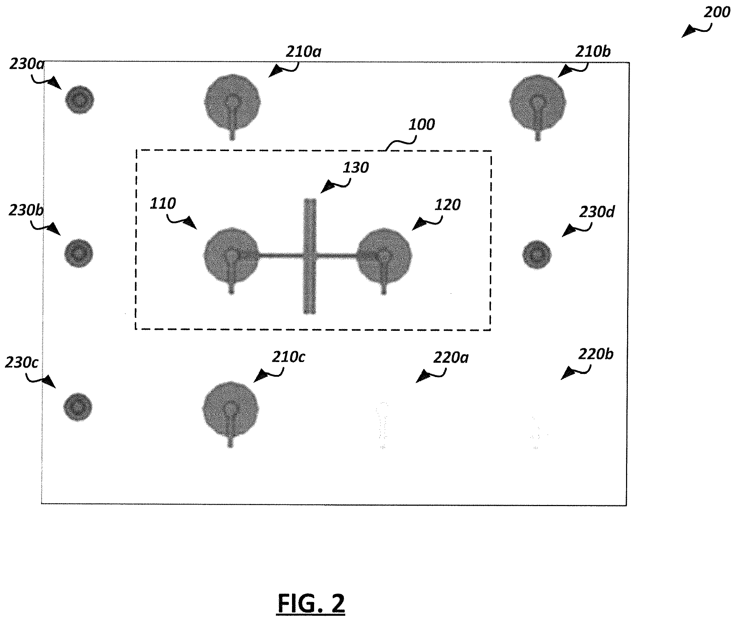

FIG. 2 illustrates the example via structures of FIGS. 1A-1B on a printed circuit board (PCB) 200 that includes other via structures in accordance with embodiments of the present disclosure. In the example shown, the via structures 110, 120 and via structures 210 are signal vias, while the via structures 220 are data strobe vias (e.g., DQS vias). The via structures 230 are ground vias. Although shown as being between signal vias in FIG. 2, a coupling structure similar to coupling structure 130 may be placed between the data strobe vias or other types of vias of the PCB 200 in addition to, or in lieu of, the coupling structure 130. For instance, a coupling structure similar to 130 placed between data strobe vias may improve differential mode coupling between the vias.

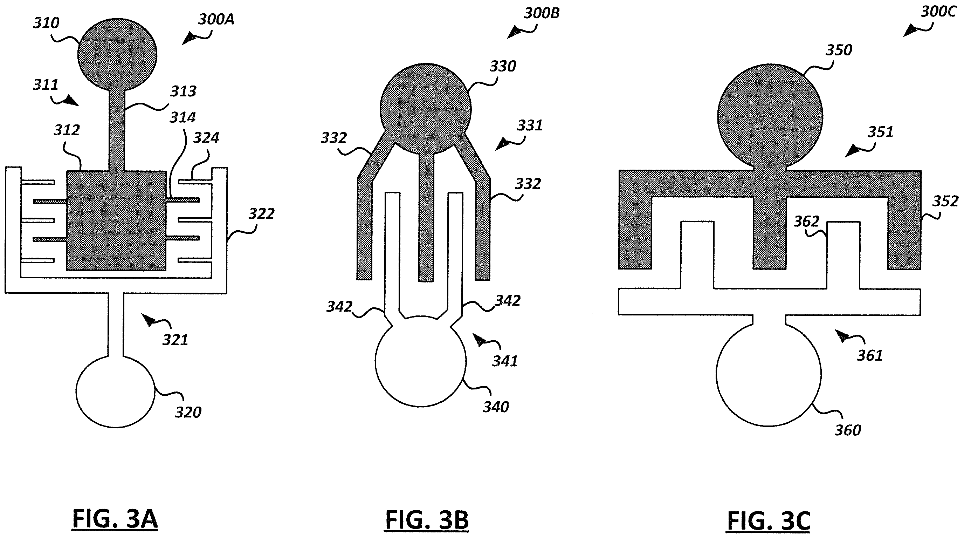

FIGS. 3A-3C illustrate example via coupling structures 300 in accordance with embodiments of the present disclosure. In the examples shown, each side of the coupling structure is on the same layer as the other in the substrate. However, in other embodiments, the respective sides of the coupling structures 300 may be in different layers of the substrate.

Referring to FIG. 3A, the example via coupling structure 300A includes coupling elements 311, 321 formed between vias 310, 320. The coupling element 311 includes a trace 313 that extends from the via 310 and forms a pad 312, which has a number of finger traces 314 extending therefrom toward the trace 322 of the coupling element 321. The coupling element 321 includes a trace 322 that extends from the via 320 in a U-shape, and the trace 322 includes finger traces 324 that extend therefrom toward the coupling element 311. The finger elements 314, 324 are arranged such that they interleave with one another and provide most of the capacitive coupling of the structure 300A.

Referring now to FIG. 3B, the example via coupling structure 300B includes coupling elements 331, 341 formed between the vias 330, 340. The example coupling element 331 includes three traces 332 extending from the via 330 generally toward the via 340, and the example coupling element 341 includes two traces 342 extending from the via 340 generally toward the via 330. The traces 332, 342 are arranged such that they interleave with one another (and are parallel) as shown.

Referring now to FIG. 3C, the example via coupling structure 300C includes coupling elements 351, 361 formed between the vias 350, 360. The coupling element 351 includes a trace that initially extends from the via 350 then splits into three branches 352 (orthogonally from the initial trace), which extend generally in the direction toward the via 360. The coupling element 361 includes a trace that initially extends from the via 360 then splits into two branches 362 (orthogonally from the initial trace), which extend generally in the direction toward the via 360. The branches 352, 362 are arranged such that they interleave with one another (and are parallel) as shown.

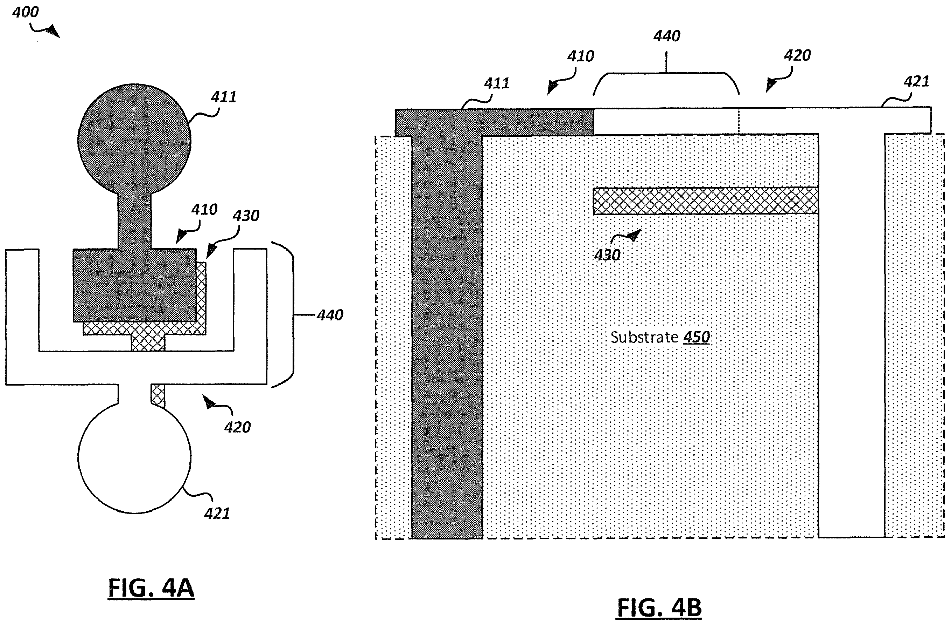

FIGS. 4A-4B illustrate another example via coupling structure 400 in accordance with embodiments of the present disclosure. In the example shown, the via coupling structure 400 includes a coupling element 410 extending from the via 411, and two coupling elements 420, 430 extending from the via 421. The coupling elements 410, 420 are on the same layer of the substrate, while the coupling element 430 is on a different layer of/within the substrate. In particular, the coupling element 410 includes a trace that extends from the via 411 and forms a pad. The coupling element 420 includes a trace that extends from the via 421 and branches out to a U-shape as shown. The U-shape portion of the coupling element 420 is formed such that the rectangular pad formation of the coupling element 410 is within the U-shape as shown, forming a coupling overlap area 440. The coupling element 430 includes a trace that extends from the via 421 in a layer underneath the coupling elements 410, 420 and forms a pad formation similar to the pad formation (e.g., same size and shape, generally) of the coupling element 410 that is underneath the coupling overlap area 440 (i.e., the pad formation of coupling element 430 is generally underneath the pad formation of the coupling element 410.

Although the example via coupling structure 400 shown in FIGS. 4A-4B includes two coupling elements on the same layer with a third coupling element on a different layer, embodiments may include three coupling elements that are each on different layers of the substrate. For instance, a first coupling element extending from a first via structure may be on a first layer of the substrate, a second coupling element extending from a second via structure may be on a second layer of the substrate, and a third coupling element extending from the second via structure may be on a third layer of the substrate. Further, additional coupling elements may be included in the via coupling structure 400, in some embodiments. In addition, although the pad formations are shown as being rectangular, other pad formation shapes may be used (e.g., circular, square, etc.).

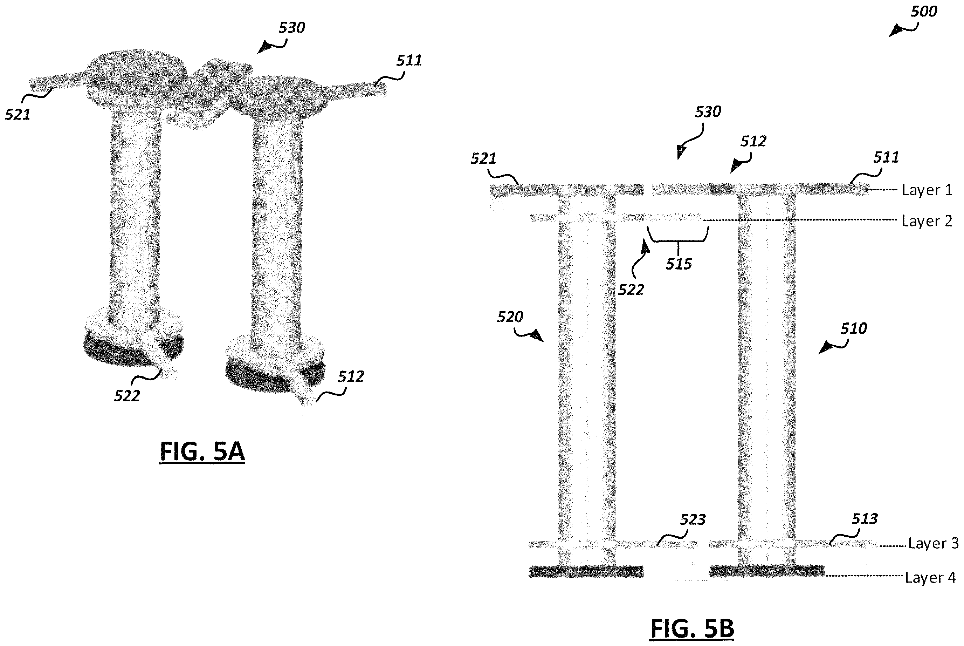

FIGS. 5A-5B illustrate another example of via structures 510, 520 capacitively coupled to one another in accordance with embodiments of the present disclosure. In particular, the example shown in FIGS. 5A-5B illustrates an example of a via coupling structure implemented in a 4L T3 motherboard. The example via structures shown each have signal entry points (511, 521) on layer 1 and signal exit points (513, 523) on layer 3. In the example show, as via coupling structure 530 is formed by coupling elements 512, 522 on different layers (i.e., layers 1 and 2, respectively) of the substrate. In particular, the coupling element 512 includes a trace that extends on layer 1 from the via structure 510 toward the via structure 520 and forms a rectangular pad formation in the coupling overlap area 515 between the via structures 510, 520. The coupling element 522 includes a trace that extends on layer 2 from the via structure 510 toward the via structure 520, and also forms a rectangular pad formation in the coupling overlap area 515 between the via structures 510, 520.

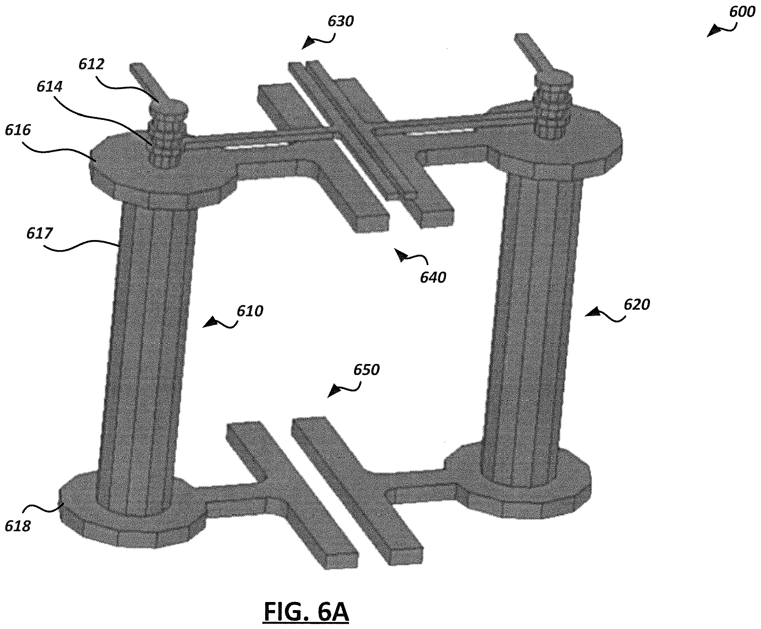

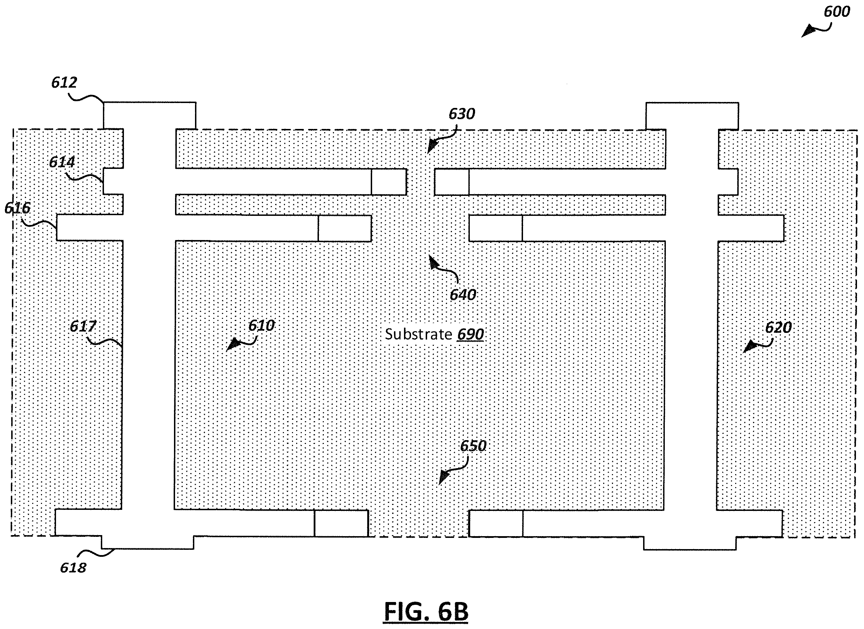

FIGS. 6A-6B illustrate yet another example of via structures capacitively coupled to one another in accordance with embodiments of the present disclosure. In particular, the example shown is similar to the example shown in FIGS. 1A-1B, but with the additional via coupling structures 640, 650. For instance, in the example shown, each via structure 610, 620 includes a signal entry point (e.g., 612), a signal exit point (e.g., 618), a micro-via transition (e.g., 614) on a layer between the entry and exit, and a barrel portion (e.g., 617) that couples the entry and exit and other layers (e.g., a plated thru hole (PTH) barrel, blind via hole (BVH) barrel, or buried via hole (BVH) barrel). The via structures may accordingly allow a signal to travel from the entry point through substrate 690 to the exit point. The entry and/or exit points may be outside or within the substrate 690, depending on the application.

Like the example of FIGS. 1A-1B, each via structure 610, 620 further defines a trace that extends toward the other via structure, with the traces forming the coupling structure 630 in an area between the via structures 610, 620. The coupling structure 630 provides a capacitive coupling between the via structures 610, 620. In addition, each via structure 610, 620 further defines another set of traces that extend toward the other via structure, with the additional traces forming the coupling structures 640, 650 in the area between the via structures 610, 620. In the example shown, each of the that form the coupling structures 630, 640, 650 are formed in a T-shape (although with different trace thicknesses), with the top of the T-shapes being parallel with one another in each coupling structure 630, 640, 650. However, the shape and form of the example coupling structures shown in FIGS. 6A-6B may be different in other embodiments, and the general formats/shapes of the coupling structures need not be the same or similar as shown.

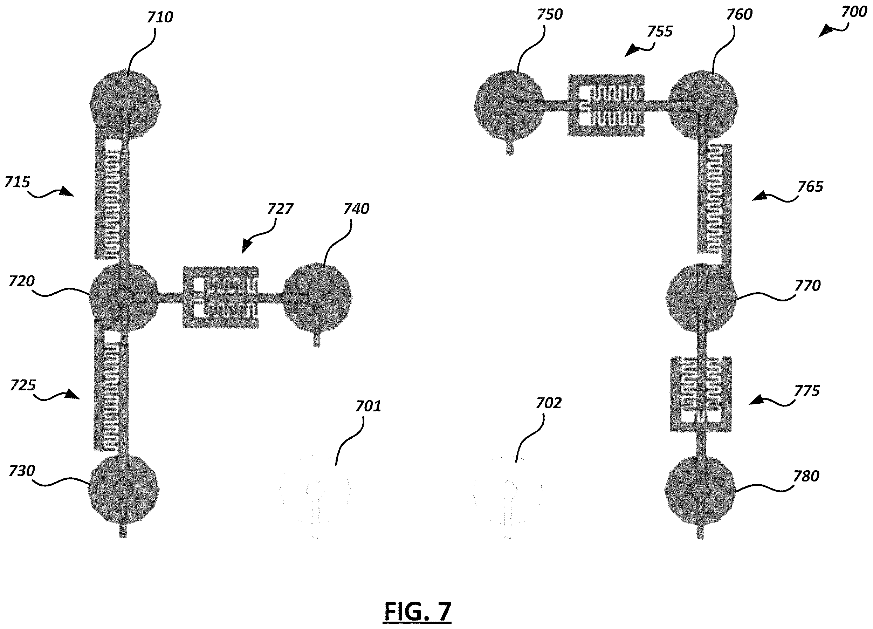

FIG. 7 illustrates an example printed circuit board (PCB) 700 having sets of three or more vias (e.g., 710, 720, 730, 740, 750, 760, 770, 780) capacitively coupled together using via coupling structures (e.g., 715, 725, 727, 735, 745, 755, 765, 775) in accordance with embodiments of the present disclosure. In the example shown, the vias 710, 720, 730, 740, 750, 760, 770, 780 are signaling vias for the PCB 700, which also includes data strobe vias 701, 702. Although not shown with a via coupling structure between them, the data strobe vias 701, 702 may, in some embodiments, also include a via coupling structure similar to one or more of the via coupling structures 715, 725, 727, 735, 745, 755, 765, 775 or another type of via coupling structure as described herein.

Because there exists a trade-off between crosstalk cancellation and reduced component impedance due to the added capacitance, simulations may be performed to optimize the design of the via coupling structures of the present disclosure, allowing an engineer the freedom to best balance the trade-offs between crosstalk mitigation and impedance matching.

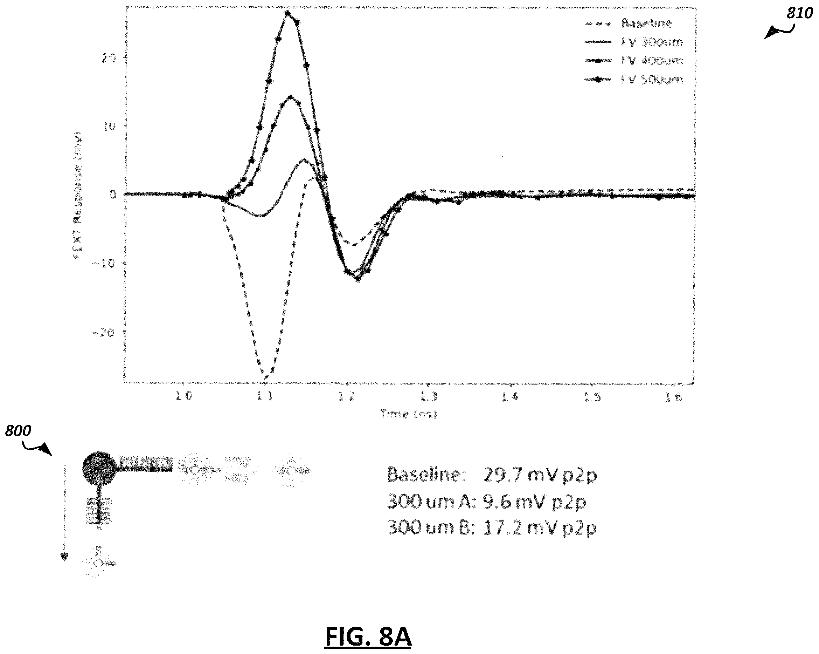

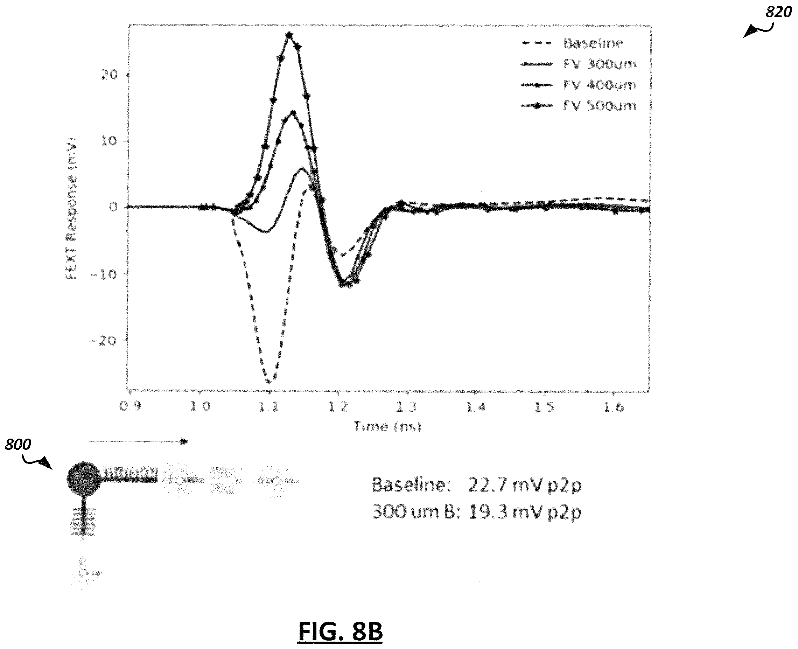

FIGS. 8A-8B illustrate example simulation results for via coupling structures of an example circuit in accordance with embodiments of the present disclosure. In particular, the results shown in the charts 810, 820 of FIGS. 8A-8B, respectively, detail the crosstalk response resulting from the stimulation of the circuit 800 shown. The results show that first-droop FEXT can be reduced relative to a baseline case (i.e., with no via coupling structure in place) by approximately 70% using the via coupling structures shown in the circuit 800, e.g., using a via coupling structure with optimized dimensions. The results also show that other, non-optimized dimensions may lead to over-compensations, indicating strong tunability for product-specific use cases.

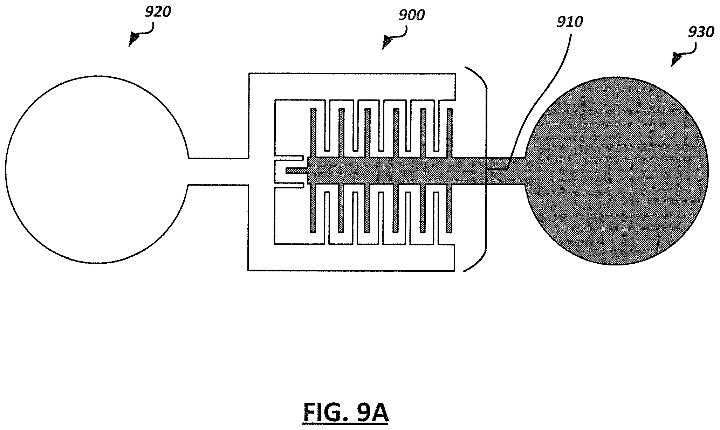

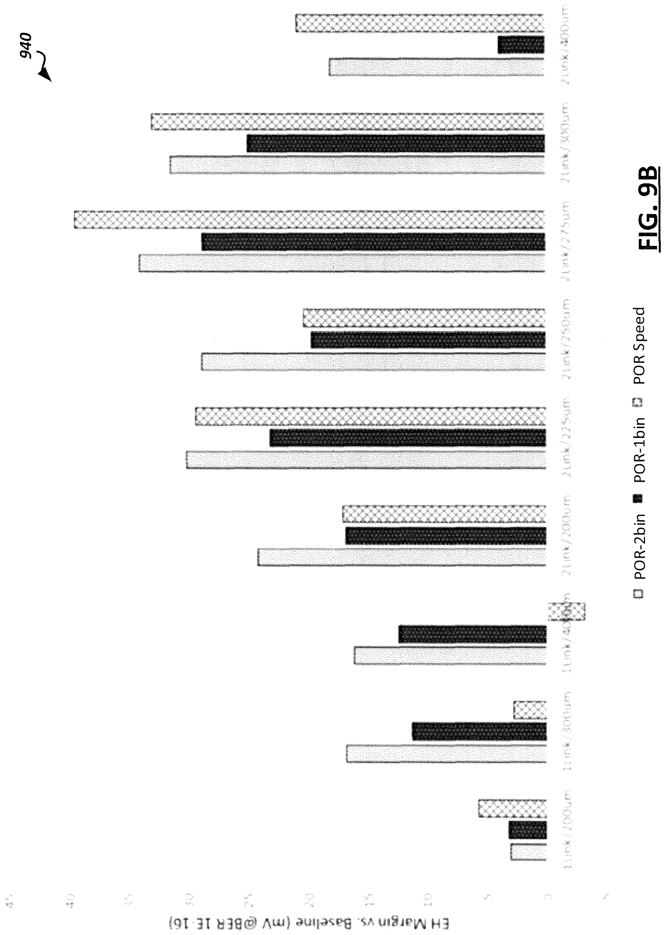

FIGS. 9A-9B illustrate additional example simulation results for another example via coupling structure 900 in accordance with embodiments of the present disclosure. In particular, FIGS. 9A-9B demonstrate an example of geometry optimization in the width 910 of the via coupling structure 900 between the vias 920, 930 shown in FIG. 9A is swept in a 3D simulation suite to best optimize the channel margin, with the results of the sweep being shown in FIG. 9B. The chart 940 FIG. 9B illustrates the effect on channel margin at different POR (Process on Record) data speeds relative to a baseline case of having no via coupling structure between the vias 920, 930 of FIG. 9A. In the chart 940, a positive Y value indicates improvement versus the baseline case, and negative Y value indicates degradation versus the baseline case. In particular, the $\gamma$-axis in the chart 940 represents eye-height (EH) margin gain at a bit error rate (BER) 10^-16 contour relative to a baseline of no via coupling structure between the via 920, 930. The 1-link/2-link indications in the chart 940 refer to the number of via coupling structures emanating from a victim line under consideration. The size indication (e.g., 200um, 300 um, etc.) indicates the width 910 of the via coupling structure 900.

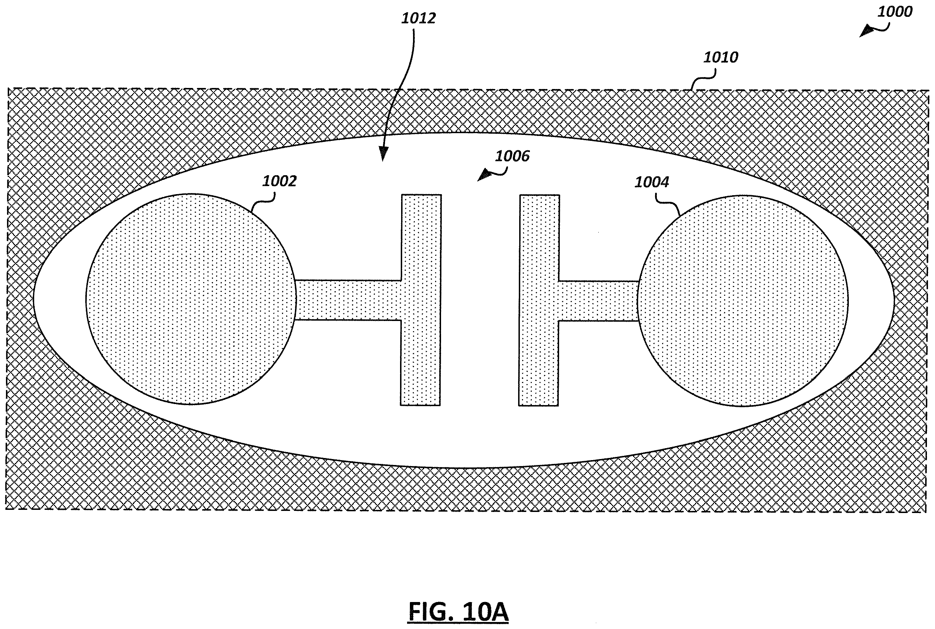

FIG. 10A illustrates an example via coupling structure 1006 between vias 1002, 1004 and a ground plane 1010 that defines a void 1012 around the vias 1002, 1004 and via coupling structure 1006 in accordance with embodiments of the present disclosure. The ground plane 1010 may be located on a different layer than each of the vias 1002, 1004 and/or the via coupling structure 1006 in certain embodiments. For example, in some embodiments, the voided ground plane 1010 may be on a layer immediately adjacent to the layer in which the via coupling structure 1006 is located. Though shown with a particular shape, the void 1012 defined by the ground plane 1010 may be of any suitable shape. By voiding the area surrounding the vias 1002, 1004 and the via coupling structure 1006 between the vias, an impedance drop caused by the introduction of the via coupling structure 1006 may be mitigated. The efficiency of this technique may be proportional to the number of layers on the stack-up and the keep out zone allowed by the layout.

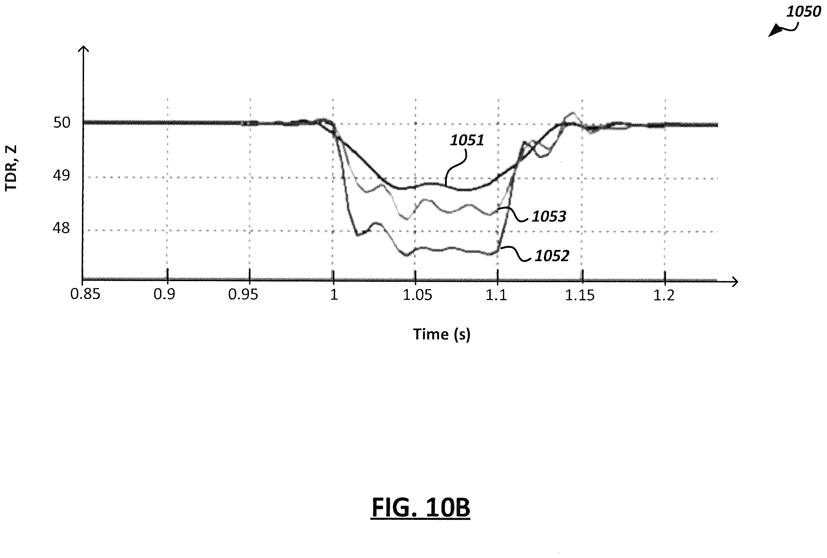

FIG. 10B illustrates example simulation results related to the voided ground plane 1010 as shown in FIG. 10A. In particular, the chart 1050 shows Time Domain Reflectometry (TDR) results for the structure, where the line 1051 relates to the scenario of the two vias having no via coupling structure in place, the line 1052 relates to the scenario of the via coupling structure being in place without the voided ground plane, and the line 1053 relates to the circuit as shown in FIG. 10A. The TDR signals may represent or be indicative of an impedance of the associated circuit, and it is observed that the impedance of the circuit drops from 1051 to 1052 due to the introduction of the via coupling structure, but line 1053 is closer to the baseline case of 1051 due to the introduction of the voided ground plane.

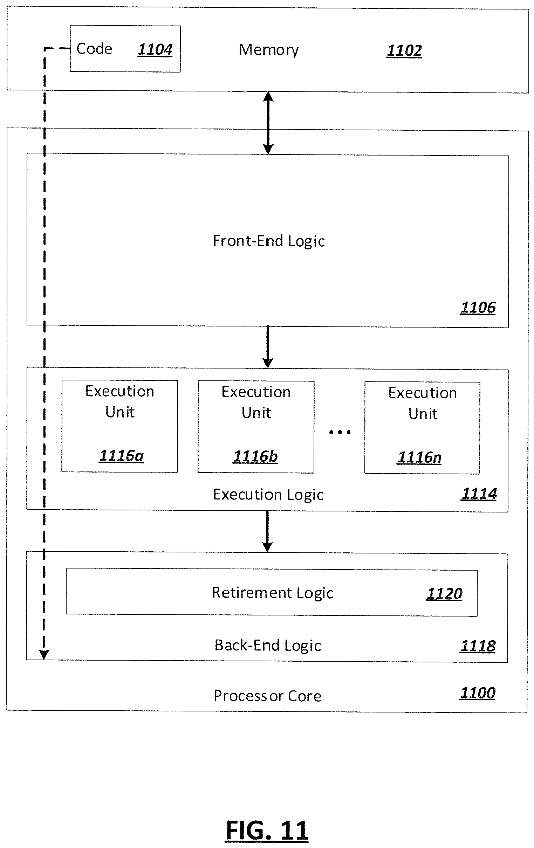

FIGS. 11-12 are block diagrams of example computer architectures that may be used in accordance with embodiments disclosed herein. For example, in some embodiments, a computer system may contain one or more aspects shown in FIGS. 11-12 and may implement one or more aspects of the present disclosure. Other computer architecture designs known in the art for processors and computing systems may also be used. Generally, suitable computer architectures for embodiments disclosed herein can include, but are not limited to, configurations illustrated in FIGS. 11-12.

FIG. 11 is an example illustration of a processor according to an embodiment. Processor 1100 is an example of a type of hardware device that can be used in connection with the implementations above. Processor 1100 may be any type of processor, such as a microprocessor, an embedded processor, a digital signal processor (DSP), a network processor, a multi-core processor, a single core processor, or other device to execute code. Although only one processor 1100 is illustrated in FIG. 11, a processing element may alternatively include more than one of processor 1100 illustrated in FIG. 11. Processor 1100 may be a single-threaded core or, for at least one embodiment, the processor 1100 may be multi-threaded in that it may include more than one hardware thread context (or "logical processor") per core.

FIG. 11 also illustrates a memory 1102 coupled to processor 1100 in accordance with an embodiment. Memory 1102 may be any of a wide variety of memories (including various layers of memory hierarchy) as are known or otherwise available to those of skill in the art. Such memory elements can include, but are not limited to, random access memory (RAM), read only memory (ROM), logic blocks of a field programmable gate array (FPGA), erasable programmable read only memory (EPROM), and electrically erasable programmable ROM (EEPROM).

Processor 1100 can execute any type of instructions associated with algorithms, processes, or operations detailed herein. Generally, processor 1100 can transform an element or an article (e.g., data) from one state or thing to another state or thing.

Code 1104, which may be one or more instructions to be executed by processor 1100, may be stored in memory 1102, or may be stored in software, hardware, firmware, or any suitable combination thereof, or in any other internal or external component, device, element, or object where appropriate and based on particular needs. In one example, processor 1100 can follow a program sequence of instructions indicated by code 1104. Each instruction enters a front-end logic 1106 and is processed by one or more decoders 1108. The decoder may generate, as its output, a micro operation such as a fixed width micro operation in a predefined format, or may generate other instructions, microinstructions, or control signals that reflect the original code instruction. Front-end logic 1106 also includes register renaming logic 1110 and scheduling logic 1112, which generally allocate resources and queue the operation corresponding to the instruction for execution.

Processor 1100 can also include execution logic 1114 having a set of execution units 1116a, 1116b, 1116n, etc. Some embodiments may include a number of execution units dedicated to specific functions or sets of functions. Other embodiments may include only one execution unit or one execution unit that can perform a particular function. Execution logic 1114 performs the operations specified by code instructions.

After completion of execution of the operations specified by the code instructions, back-end logic 1118 can retire the instructions of code 1104. In one embodiment, processor 1100 allows out of order execution but requires in order retirement of instructions. Retirement logic 1120 may take a variety of known forms (e.g., reorder buffers or the like). In this manner, processor 1100 is transformed during execution of code 1104, at least in terms of the output generated by the decoder, hardware registers and tables utilized by register renaming logic 1110, and any registers (not shown) modified by execution logic 1114.

Although not shown in FIG. 11, a processing element may include other elements on a chip with processor 1100. For example, a processing element may include memory control logic along with processor 1100. The processing element may include I/O control logic and/or may include I/O control logic integrated with memory control logic. The processing element may also include one or more caches. In some embodiments, nonvolatile memory (such as flash memory or fuses) may also be included on the chip with processor 1100.

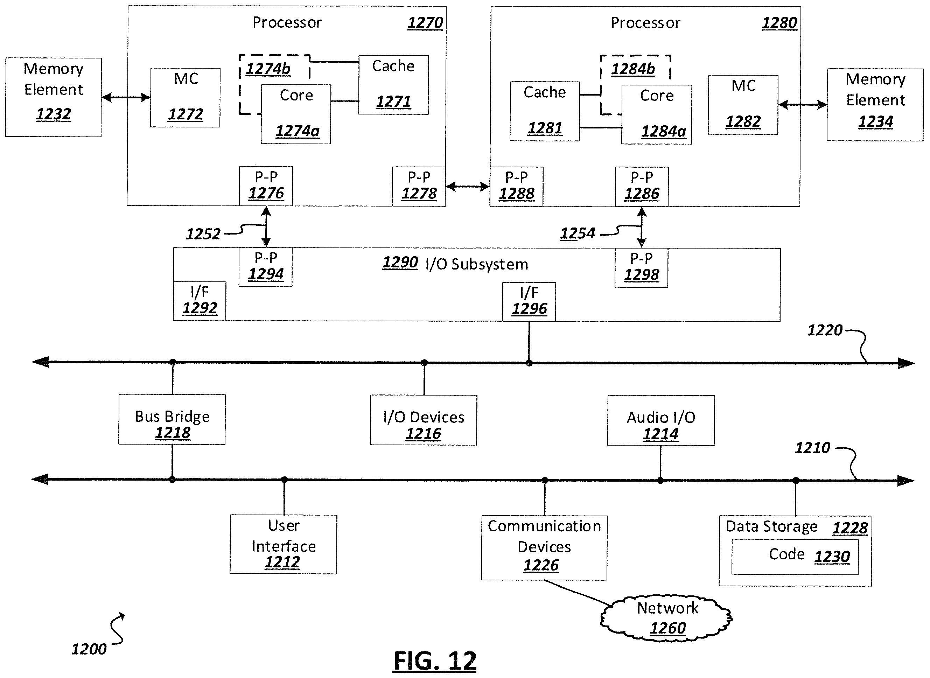

FIG. 12 illustrates a computing system 1200 that is arranged in a point-to-point (PtP) configuration according to an embodiment. In particular, FIG. 12 shows a system where processors, memory, and input/output devices are interconnected by a number of point-to-point interfaces. Generally, one or more of the computing systems described herein may be configured in the same or similar manner as computing system 1200.

Processors 1270 and 1280 may also each include integrated memory controller logic (MC) 1272 and 1282 to communicate with memory elements 1232 and 1234. In alternative embodiments, memory controller logic 1272 and 1282 may be discrete logic separate from processors 1270 and 1280. Memory elements 1232 and/or 1234 may store various data to be used by processors 1270 and 1280 in achieving operations and functionality outlined herein.

Processors 1270 and 1280 may be any type of processor, such as those discussed in connection with other figures. Processors 1270 and 1280 may exchange data via a point-to-point (PtP) interface 1250 using point-to-point interface circuits 1278 and 1288, respectively. Processors 1270 and 1280 may each exchange data with a chipset 1290 via individual point-to-point interfaces 1252 and 1254 using point-to-point interface circuits 1276, 1286, 1294, and 1298. Chipset 1290 may also exchange data with a co-processor 1238, such as a highperformance graphics circuit, machine learning accelerator, or other co-processor 1238, via an interface 1239, which could be a PtP interface circuit. In alternative embodiments, any or all of the PtP links illustrated in FIG. 12 could be implemented as a multi-drop bus rather than a PtP link.

Chipset 1290 may be in communication with a bus 1220 via an interface circuit 1296. Bus 1220 may have one or more devices that communicate over it, such as a bus bridge 1218 and I/O devices 1216. Via a bus 1210, bus bridge 1218 may be in communication with other devices such as a user interface 1212 (such as a keyboard, mouse, touchscreen, or other input devices), communication devices 1226 (such as modems, network interface devices, or other types of communication devices that may communicate through a computer network 1260), audio I/O devices 1216, and/or a data storage device 1228. Data storage device 1228 may store code 1230, which may be executed by processors 1270 and/or 1280. In alternative embodiments, any portions of the bus architectures could be implemented with one or more PtP links.

The computer system depicted in FIG. 12 is a schematic illustration of an embodiment of a computing system that may be utilized to implement various embodiments discussed herein. It will be appreciated that various components of the system depicted in FIG. 12 may be combined in a system-on-a-chip (SoC) architecture or in any other suitable configuration capable of achieving the functionality and features of examples and implementations provided herein.

While some of the systems and solutions described and illustrated herein have been described as containing or being associated with a plurality of elements, not all elements explicitly illustrated or described may be utilized in each alternative implementation of the present disclosure. Additionally, one or more of the elements described herein may be located external to a system, while in other instances, certain elements may be included within or as a portion of one or more of the other described elements, as well as other elements not described in the illustrated implementation. Further, certain elements may be combined with other components, as well as used for alternative or additional purposes in addition to those purposes described herein.

Further, it should be appreciated that the examples presented above are nonlimiting examples provided merely for purposes of illustrating certain principles and features and not necessarily limiting or constraining the potential embodiments of the concepts described herein. For instance, a variety of different embodiments can be realized utilizing various combinations of the features and components described herein, including combinations realized through the various implementations of components described herein. Other implementations, features, and details should be appreciated from the contents of this Specification.

Although this disclosure has been described in terms of certain implementations and generally associated methods, alterations and permutations of these implementations and methods will be apparent to those skilled in the art. For example, the actions described herein can be performed in a different order than as described and still achieve the desirable results. As one example, the processes depicted in the accompanying figures do not necessarily require the particular order shown, or sequential order, to achieve the desired results. In certain implementations, multitasking and parallel processing may be advantageous. Additionally, other user interface layouts and functionality can be supported. Other variations are within the scope of the following claims.

While this specification contains many specific implementation details, these should not be construed as limitations on the scope of any embodiments or of what may be claimed, but rather as descriptions of features specific to particular embodiments. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

The following examples pertain to embodiments in accordance with this Specification. It will be understood that certain examples may be combined with certain other examples, in certain embodiments.

Example 1 includes an apparatus comprising: a first via structure in a substrate; second via structure in the substrate; wherein the first via structure defines a first coupling element that extends from the first via structure toward the second via structure and the second via structure defines a second coupling element that extends from the second via structure toward the first via structure such that the first and second coupling elements capacitively couple with one another in an area between the first and second via structures.

Example 2 includes the subject matter of Example 1, wherein the first and second coupling elements are on the same layer within the substrate.

Example 3 includes the subject matter of Example 1, wherein the first and second coupling elements are on different layers within the substrate.

Example 4 includes the subject matter of Example 1, wherein the first and second coupling elements comprise traces that are parallel with one another.

Example 5 includes the subject matter of Example 1, wherein the first coupling element comprises a set of traces that interleave with a set of traces of the second coupling element.

Example 6 includes the subject matter of Example 1, wherein the first and second coupling elements each comprise a main trace portion and a plurality of finger traces extending outward from the main trace portion, the finger traces of the first coupling element interleaving with the finger traces of the second coupling element.

Example 7 includes the subject matter of Example 6, wherein the finger traces extend orthogonally from the main trace portions.

Example 8 includes the subject matter of Example 1, wherein the second via structure further comprises a third coupling element that extends from the second via structure toward the first via structure such that the first and third coupling elements capacitively couple with one another in the area between the first and second via structures.

Example 9 includes the subject matter of Example 8, wherein the first and third coupling elements are on different layers within the substrate.

Example 10 includes the subject matter of Example 1, wherein the first via structure further defines a third coupling element that extends from the first via structure toward the second via structure and the second via structure further defines a fourth coupling element that extends from the second via structure toward the first via structure such that the third and fourth coupling elements capacitively couple with one another in the area between the first and second via structures.

Example 11 includes the subject matter of Example 1, further comprising a third via structure in the substrate, wherein the third via structure defines a third coupling element that extends from the third via structure toward the second via structure such that the second and third coupling elements capacitively couple with one another in an area between the second and third via structures.

Example 12 includes the subject matter of any preceding Example, further comprising a ground plane in the substrate on a different layer than the first and second coupling elements, the ground plane defining a void in an area above or below the area in which first and second coupling elements capacitively couple with one another.

Example 13 includes the subject matter of Example 12, wherein the first and second coupling elements are on a first layer of the substrate and the ground plane is on a second layer of the substrate adjacent to the first layer.

Example 14 includes a system comprising: a substrate; a set of signal vias formed in the substrate, wherein the set of signal vias comprises first and second signal vias capacitively coupled to one another through a via coupling structure formed between the first and second signal vias, the via coupling structure defined by: a first coupling element that extends from the first signal via toward the second signal via; and a second coupling element that extends from the second signal via toward the first signal via such that the first and second coupling elements capacitively couple with one another in an area between the first and second signal via.

Example 15 includes the subject matter of Example 14, wherein the first and second coupling elements each comprise a main trace portion and a plurality of finger traces extending outward from the main trace portion, the finger traces of the first coupling element interleaving with the finger traces of the second coupling element. The finger traces may extend orthogonally from the main trace portions.

Example 16 includes the subject matter of Example 14, wherein the via coupling structure is a first via coupling structure, and the system further comprises a second via coupling structure defined by: a third coupling element that extends from the first signal via toward the second signal via; and a fourth coupling element that extends from the second signal via toward the first signal via such that the third and fourth coupling elements capacitively couple with one another in the area between the first and second signal vias. The first and third coupling elements may be on different layers within the substrate.

Example 17 includes the subject matter of Example 14, wherein the via coupling structure is a first via coupling structure, and the set of vias further comprises a third signal via capacitively coupled to the second signal via through a second via coupling structure formed between the second and third signal vias, the second via coupling structure defined by a third coupling element that extends from the second signal via toward the third signal via and a fourth coupling element that extends from the third signal via toward the second signal via such that the second and third coupling elements capacitively couple with one another in an area between the second and third signal vias.

Example 18 includes the subject matter of Example 14, further comprising a set of data strobe vias, wherein the set of data strobe vias comprises first and second data strobe vias capacitively coupled to one another through a via coupling structure formed between the first and second data strobe vias, the via coupling structure defined by: a third coupling element that extends from the first data strobe via toward the second data strobe via; and a fourth coupling element that extends from the second data strobe via toward the first data strobe via such that the third and fourth coupling elements capacitively couple with one another in an area between the first and second data strobe vias.

Example 19 includes the subject matter of Example 14, further comprising a ground plane formed in the substrate on a different layer than the first and second coupling elements, the ground plane defining a void in an area above or below the area in which first and second coupling elements capacitively couple with one another. The first and second coupling elements may be on a first layer of the substrate and the ground plane may be on a second layer of the substrate adjacent to the first layer.

Example 20 includes the subject matter of any of Examples 14-19, wherein the system comprises one of a motherboard, a memory module, or a processor.

Example 21 includes the subject matter of any of Examples 14-19, wherein the first and second coupling elements are on the same layer within the substrate.

Example 22 includes the subject matter of any of Examples 14-19, wherein the first and second coupling elements are on different layers within the substrate.

Example 23 includes the subject matter of any of Examples 14-19, wherein the first and second coupling elements comprise traces that are parallel with one another.

Example 24 includes the subject matter of any of Examples 14-19, wherein the first coupling element comprises a set of traces that interleave with a set of traces of the second coupling element.

Example 25 includes an apparatus comprising: a first via structure in a substrate; a second via structure in the substrate; and means for capacitively coupling the first and second via structures, wherein the means in an area between the first and second via structures.

Example 26 includes the subject matter of Example 25, wherein the means comprises first means extending from the first via structure toward the second via structure and a second means extending from the second via structure toward the first via structure.

Example 27 includes the subject matter of Example 25, wherein means further comprises a third means extending from the second via structure toward the first via structure, wherein the third means is above or below the second means.

Example 28 includes the subject matter of Example 25, wherein the means is a first means for capacitively coupling the first and second via structures, and the apparatus further comprises a second means for capacitively coupling the first and second via structures in the area between the first and second via structures.

Example 29 includes the subject matter of Example 25, wherein the means is a first means for capacitively coupling the first and second via structures, and the apparatus further comprises: a third via structure in the substrate; and a second means for capacitively coupling the second and third via structures in an area between the second and third via structures.

Example 30 includes a system comprising an apparatus of any of Examples 1-13 and 25-29.

Example 31 includes the subject matter of Example 30, wherein the system comprises one of a motherboard, a memory module, or a processor.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results.

## Claims

1. An apparatus comprising:

   a first via structure in a substrate; and
   a second via structure in the substrate;
   wherein the first via structure defines a first coupling element that extends from the first via structure toward the second via structure and the second via structure defines a second coupling element that extends from the second via structure toward the first via structure such that the first and second coupling elements capacitively couple with one another in an area between the first and second via structures.

2. The apparatus of claim 1, wherein the first and second coupling elements are on the same layer within the substrate.

3. The apparatus of claim 1, wherein the first and second coupling elements are on different layers within the substrate.

4. The apparatus of claim 1, wherein the first and second coupling elements comprise traces that are parallel with one another.

5. The apparatus of claim 1, wherein the first coupling element comprises a set of traces that interleave with a set of traces of the second coupling element.

6. The apparatus of claim 1, wherein the first and second coupling elements each comprise a main trace portion and a plurality of finger traces extending outward from the main trace portion, the finger traces of the first coupling element interleaving with the finger traces of the second coupling element.

7. The apparatus of claim 6, wherein the finger traces extend orthogonally from the main trace portions.

8. The apparatus of claim 1, wherein the second via structure further comprises a third coupling element that extends from the second via structure toward the first via structure such that the first and third coupling elements capacitively couple with one another in the area between the first and second via structures.

9. The apparatus of claim 8, wherein the first and third coupling elements are on different layers within the substrate.

10. The apparatus of claim 1, wherein the first via structure further defines a third coupling element that extends from the first via structure toward the second via structure and the second via structure further defines a fourth coupling element that extends from the second via structure toward the first via structure such that the third and fourth coupling elements capacitively couple with one another in the area between the first and second via structures.

11. The apparatus of claim 1, further comprising a third via structure in the substrate, wherein the third via structure defines a third coupling element that extends from the third via structure toward the second via structure such that the second and third coupling elements capacitively couple with one another in an area between the second and third via structures.

12. The apparatus of any one of claims 1-11, further comprising a ground plane in the substrate on a different layer than the first and second coupling elements, the ground plane defining a void in an area above or below the area in which first and second coupling elements capacitively couple with one another.

13. The apparatus of claim 12, wherein the first and second coupling elements are on a first layer of the substrate and the ground plane is on a second layer of the substrate adjacent to the first layer.

14. A system comprising:

    a processor;
    a memory module; and
    an apparatus of any preceding claim.

15. The system of claim 14, wherein the apparatus is implemented in a motherboard.

FIG. 1A

EP 4 064 801 A1

**FIG. 1B**

FIG. 2

**FIG. 3A**

**FIG. 3B**

**FIG. 3C**

FIG. 4B

FIG. 4A

Substrate 450

FIG. 5B

FIG. 5A

EP 4 064 801 A1

**FIG. 6A**

FIG. 6B

FIG. 7

FIG. 8A

EP 4 064 801 A1

**FIG. 8B**

**FIG. 9A**

**FIG. 9B**

EH Margin vs. Baseline (mV) @BER 1E-16

Legend: POR-2bin · POR-1bin · POR Speed

**FIG. 10A**

EP 4 064 801 A1

**FIG. 10B**

Code    _1104_          Memory          _1102_

Front-End Logic

_1106_

| Execution Unit _1116a_ | Execution Unit _1116b_ | ... | Execution Unit _1116n_ |

Execution Logic          _1114_

Retirement Logic          _1120_

Back-End Logic          _1118_

Processor Core          _1100_

## FIG. 11

**FIG. 12**

Europäisches
Patentamt

European
Patent Office

Office européen
des brevets

# EUROPEAN SEARCH REPORT

Application Number

EP 22 15 7644

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 854 488 A1 (INTEL CORP [US]) 1 April 2015 (2015-04-01) * paragraphs [0007] - [0013], [0024]; figures 1-2,6 * | 1,3-5, 14,15 | INV. H05K1/02 H05K1/11 H05K1/16 H01P1/203 H04B5/00 |
| X | US 2014/268614 A1 (ZHANG ZHICHAO [US] ET AL) 18 September 2014 (2014-09-18) * paragraphs [0018] - [0023], [0034] - [0035]; figures 1A-C,5A * | 1,3-5, 8-10,14, 15 | ADD. H05K3/42 |
| X | US 2016/014887 A1 (KASAHARA YOSHIAKI [JP] ET AL) 14 January 2016 (2016-01-14) * paragraphs [0072], [0077] - [0086], [0106] - [0108]; figures 1-3,21-22 * | 1,2,4,5, 8,10-13 | |
| X | US 2008/009199 A1 (HASHIM AMID I [US]) 10 January 2008 (2008-01-10) * paragraph [0052]; figure 5E * | 1,2,4-8, 10 | |

TECHNICAL FIELDS
SEARCHED (IPC)

H05K

The present search report has been drawn up for all claims

| Place of search | Date of completion of the search | Examiner |
|---|---|---|
| The Hague | 12 August 2022 | Tomezak, Alexandre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 15 7644

This annex lists the patent family members relating to the patent documents cited in the above-mentioned European search report.
The members are as contained in the European Patent Office EDP file on
The European Patent Office is in no way liable for these particulars which are merely given for the purpose of information.

12-08-2022

| Patent document cited in search report | | Publication date | Patent family member(s) | | Publication date |
|---|---|---|---|---|---|
| EP 2854488 | A1 | 01-04-2015 | CN | 104519656 A | 15-04-2015 |
| | | | EP | 2854488 A1 | 01-04-2015 |
| | | | US | 2015085458 A1 | 26-03-2015 |
| US 2014268614 | A1 | 18-09-2014 | CN | 104051425 A | 17-09-2014 |
| | | | US | 2014268614 A1 | 18-09-2014 |
| US 2016014887 | A1 | 14-01-2016 | JP | WO2014136595 A1 | 09-02-2017 |
| | | | US | 2016014887 A1 | 14-01-2016 |
| | | | WO | 2014136595 A1 | 12-09-2014 |
| US 2008009199 | A1 | 10-01-2008 | CN | 101536271 A | 16-09-2009 |
| | | | GB | 2452211 A | 25-02-2009 |
| | | | US | 2008009199 A1 | 10-01-2008 |
| | | | WO | 2008005116 A1 | 10-01-2008 |

EPO FORM P0459

For more details about this annex : see Official Journal of the European Patent Office, No. 12/82